# EUROPEAN PATENT APPLICATION

(11) **EP 0 697 807 A2**
(43) Date of publication of application: **21.02.1996**
(21) Application number: 95305591.0
(22) Date of filing: 10.08.1995
(51) Int. Cl.: H05K 7/20

(54) **Cooled housing**

(30) Priority: 18.08.1994 GB 9416695
(71) Applicant: LUCAS INDUSTRIES PUBLIC LIMITED COMPANY, Solihull, West Midlands B91 3TX (GB)
(72) Inventor: Webster, Steven John, Dosthill, Staffordshire, B77 1JR (GB); Salt, Christopher, Castle Bromwich, Birmingham, B36 9SQ (GB)
(74) Representative: Robinson, John Stuart

(57) **Abstract**

A cooled housing for electronic circuit cards comprises housing walls (20, 22, 24) to which are attached wall portions (26, 28). Covers (29, 32, 34, 36) cooperate with the walls (20, 22, 24) and wall portions (26, 28) to form channels which, on at least one wall (20, 24), are serpentine. The channels are arranged in series between an inlet (40) and an outlet (42) for a coolant, such as fuel in aerospace applications.

## Description

The present invention relates to a cooled housing. Such a housing is suitable for containing electronic components and the like.

US 5 057 968 discloses a cooled housing for electronic circuit boards. The boards are held between guide rails disposed at opposite sides of the housing. The guide rails have meandering passages formed therein to allow the flow of a coolant within the guide rails.

US 4 646 202 discloses a cabinet for electronic circuit boards. The cabinet has two cavities defined between inner, intermediate and outer walls of the cabinet. The cavities can be cooled by different fluids, such as air and a liquid. The cabinet construction is relatively complex.

According to the present invention, there is provided a cooled housing comprising a plurality of housing walls, at least one cover, a plurality of wall portions, an inlet and an outlet, characterised in that the wall portions space the or each cover from a respective one of the housing walls to define a serpentine channel, communicating with the inlet and the outlet to permit flow of fluid for cooling.

The at least one cover may comprise a plurality of covers cooperating with the wall portions and the respective ones of the housing walls to define a plurality of channels, at least some of which are serpentine and which are arranged in series for fluid flow between the inlet and the outlet.

The wall portions may be integral with the housing walls. The wall portions may stand proud of the housing walls. Alternatively, a recess may be formed in one or more of the housing walls and the walls of the recess may act as the wall portions. As a further alternative, some or all of the wall portions may be carried on one or more of the covers or may be separate from the housing walls and covers.

One or more of the wall portions may define the periphery of at least one chamber and one or more further wall portions may extend within the at least one chamber to define a meandering channel therein.

In a preferred embodiment of the present invention, there is provided a housing for electronic components having a plurality of housing walls, at least first, second and third of which are profiled so as to define open channels therein, the at least first ,second and third walls cooperating with respective covers to close the channels and to define a duct extending over at least the first, second and third housing walls, the duct being in fluid flow communication with an inlet and an outlet and having a meandering path over at least two of the housing walls.

The depth and width of the channels/duct can be easily controlled. Furthermore, relatively wide channels exhibit good turbulent flow of fluid therein with little pressure drop. Additionally, the channels cover a relatively large surface area of the housing thereby enhancing cooling of the housing.

The covers may be welded at their periphery to the wall portions. Furthermore, spot welds may be made between the cover and wall portions completely covered thereby. Such welds allow higher fluid pressures to be accommodated within the channels/duct.

The present invention will further be described, by way of example, with reference to the accompanying drawings, in which:
Figure 1 is a schematic diagram of an electronics enclosure constituting a first embodiment of the present invention; and
Figure 2 is a schematic diagram of an electronics enclosure constituting a second embodiment of the present invention.

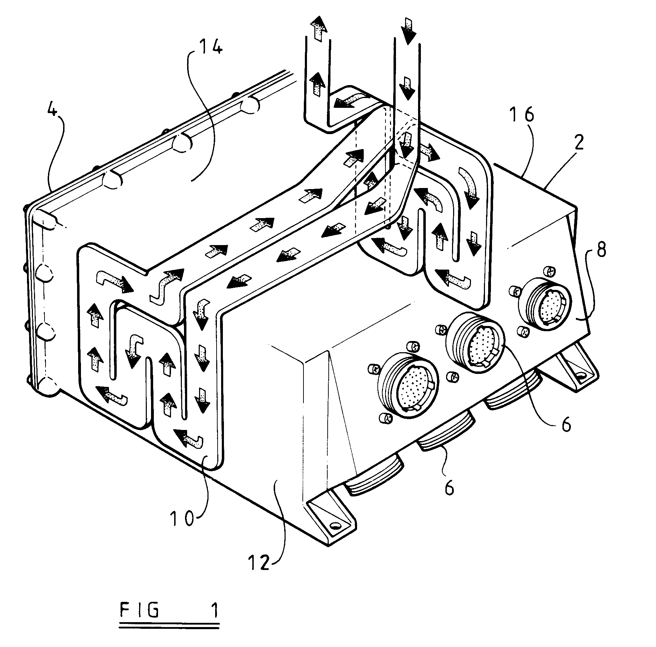

The housing 2 shown in Figure 1 is arranged to enclose a plurality of circuit boards carrying electronic components. Physical access to the circuit boards (not shown) is made via a removable wall 4 of the housing. Electrical access is made via multipin connectors 6 extending through a wall 8 of the housing. A meandering or serpentine duct 10 is formed over three walls 12, 14 and 16 of the housing and is defined by webs (i.e. small walls standing proud of the walls 12, 14 and 16) which are formed during casting of the housing 2. As an alternative to casting, the duct 10 may be fabricated, for instance by soldering or welding the webs to the walls 12, 14 and 16. An aluminium alloy plate is welded over the webs so as to close the duct 10.

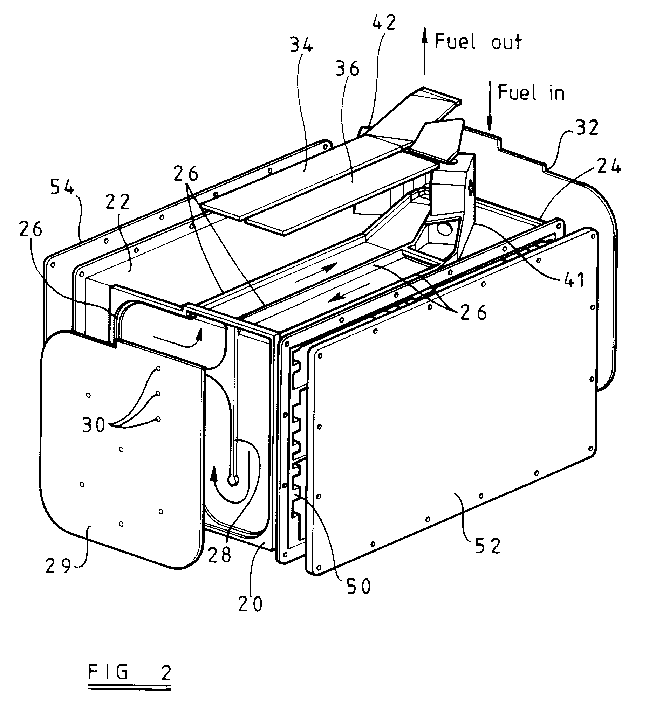

The housing shown in Figure 2 has first, second and third walls 20, 22 and 24, respectively, having webs 26 and 28 formed thereon. The web 26 defines the outer wall of the duct, whereas the web 28 is an internal wall separating one part of the duct from another part thereof.

A cover 29 is shaped so as to match the outline of the web 26 on the first wall 20. The cover 29 is welded around the periphery thereof to the web 26 so as to form a fluid tight seal and thereby a fluid tight duct. Furthermore, small holes 30 are formed in the cover in alignment with the web 28 so as to allow further welds to be made between the cover 29 and the web 28.

A similar cover 32 is welded over webs formed in the third wall 24. Further covers 34 and 36 are welded to the webs 26 formed on the second wall 22. Inlet and outlet ports 40 and 42 are formed on the second wall 22 and communicate with the interior of the duct.

Cards of electronic components and the like are held by a rack 50 within the housing. Walls 52 and 54 are removably attached to flanges formed on the first, second and third walls and a further fourth wall (not shown) parallel to the second wall, so as to close the housing.

The housing allows coolant, such as fuel, to pass along the duct and around side walls and an upper surface of the housing. The duct is arranged such that the meandering or serpentine regions of the duct formed on the first and third walls 20 and 24 are in series. This arrangement aids in purging air from the duct and provides an even coolant flow throughout the duct.

The aluminium case and covers are welded together in such a manner that relatively high fuel pressures can be withstood without fracture and with little case distortion. The welds between the covers and the web 28 increase the fuel pressure that the cover 29 can withstand.

Such a housing is suitable for use within an aviation environment where fuel is available for cooling purposes.

It is thus possible to provide an enclosure for electronic components which is robust and simple to fabricate and which allows heat to be extracted efficiently from the housing so as to maintain the components at acceptable working temperatures.

Although the above embodiments show the meandering or serpentine duct 10 being formed over three of the housing walls, the duct 10 can also be formed over just one or any number of the housing walls. It is preferable to form the duct over the housing wall or at least one of the housing walls which provides edge cooling for circuit cards in the enclosure, for instance the walls 20 and 24 shown in Figure 2 with the racks 50 for the circuit cards.

The duct 10 may be sized to give adequate cooling flow at low pressure drop. The use of smooth curves within the duct avoids the occurrence of flow separation/stagnation areas which can occur with sharp corners. The serpentine path ensures adequate cooling of substantial areas of the housing while preventing the formation of stagnant areas of coolant.

## Claims

1. A cooled housing comprising a plurality of housing walls (4, 8, 12, 14, 16, 20, 22, 24, 52, 54), at least one cover (29, 32, 34, 36), a plurality of wall portions (26, 28), an inlet (40), and an outlet (42), characterised in that the wall portions (26, 28) space the or each cover (29, 32, 34, 36) from a respective one of the housing walls (12, 14, 16, 20, 22, 24) to define a serpentine channel (10) communicating with the inlet (40) and the outlet (42) to permit flow of fluid for cooling.

2. A housing as claimed in Claim 1, characterised in that the at least one cover (29, 32, 34, 36) comprises a plurality of covers (29, 32, 34, 36) cooperating with the wall portions (26, 28) and the respective ones of the housing walls (12, 14, 1 6, 20, 22, 24) to define a plurality of channels (10), at least some of which are serpentine and which are arranged in series for fluid flow between the inlet (40) and the outlet (42).

3. A housing as claimed in Claim 1 or 2, characterised in that the wall portions (26, 28) are integral with the or each respective one of the housing walls (12, 14, 16, 20, 22, 24).

4. A housing as claimed in any one of the preceding claims, characterised in that the wall portions (26, 28) are defined by at least one recess in the or each respective one of the housing walls (12, 14, 16, 20, 22, 24).

5. A housing as claimed in Claim 1 or 2, characterised in that at least one of the wall portions (26, 28) is carried on the at least one cover (29, 32, 34, 36).

6. A housing as claimed in Claim 1 or 2, characterised in that the wall portions (26, 28) are separate from the or each respective one of the housing walls (12, 14, 16, 20, 22, 24) and the at least one cover (29, 32, 34, 36).

7. A housing as claimed in any one of the preceding claims, characterised in that at least one of the wall portions (26, 28) is common to and separates first and second portions of the serpentine channel.

8. A housing as claimed in any one of the preceding claims, characterised in that the periphery of the at least one cover (29, 32, 34, 36) is sealed to the wall portions (26, 28) by a weld.

9. A housing as claimed in Claim 8, characterised in that the weld comprises a plurality of spot welds.
